# EUROPÄISCHE PATENTSCHRIFT

(11) **EP 2 868 176 B1**
(45) Veröffentlichungstag und Bekanntmachung des Hinweises auf die Patenterteilung: **02.09.2020**
(21) Anmeldenummer: 13742169.9
(22) Anmeldetag: 27.06.2013
(51) Int. Cl.: H05K 9/00, H05K 1/02, H05K 1/18

(54) **FERTIGUNGSPROZESSOPTIMIERTE FILTEREINRICHTUNG**
PRODUCTION-PROCESS-OPTIMIZED FILTER DEVICE
SYSTÈME DE FILTRAGE À PROCÉDÉ DE FABRICATION OPTIMISÉ

(30) Priorität: 27.06.2012 DE 102012210998
(43) Veröffentlichungstag der Anmeldung: 06.05.2015
(73) Patentinhaber: Continental Automotive GmbH, 30165 Hannover (DE)
(72) Erfinder: BERBERICH, Reinhold, 60439 Frankfurt (DE); DAMMKÖHLER, Jörg, 65779 Kelkheim (DE)
(86) Internationale Anmeldenummer: PCT/EP2013/063487
(87) Internationale Veröffentlichungsnummer: WO 2014/001441

(56) Entgegenhaltungen:
- EP-A1- 2 117 285
- GB-A- 1 249 823
- US-A1- 2009 021 091

## Beschreibung

Die vorliegende Erfindung betrifft eine Filtereinrichtung gemäß dem Oberbegriff des Anspruchs 1 sowie ein Steuergerät für eine Servolenkungsvorrichtung mit einer erfindungsgemäßen Filtereinrichtung.

Aus dem Stand der Technik ist Folgendes bekannt: Bislang wurden zur Reduzierung elektromagnetischer Störungen, insbesondere in Versorgungsleitungen, sogenannte Common-Mode-Chokes eingesetzt welche aus zwei gegensinnig gewickelten Spulen mit einem weichmagnetischen Kern bestehen. Diese werden in der Regel durch Löten oder Schweißen in den zu filternden Signalpfad eingebracht.

Nachteilig dabei ist, dass ein einmal gewähltes Design der Schaltungsanordnung nicht mehr wahlfrei mit solch einem Filter bestückt werden kann, d. h. ein Verzicht auf den Filter macht i. d. R. zu einer Änderung des Designs der Schaltungsanordnung notwendig. Wenn es sich bei den Schaltungsanordnungen um Zulieferteile handelt, kann der Kunde als Abnehmer nicht je nach Bedarf entscheiden, ob die Schaltungsanordnung mit einem Filter bestückt werden soll oder nicht und ist an das ursprüngliche Design gebunden.

Es sind O-förmige Kerne bekannt welche z.B. über Blechleitungen geschoben werden. Gleichwohl müssen diese sequentiell verarbeitet werden und benötigen in der Produktion eine Vielzahl einzelner Prozessschritte wie Löten oder Schweißen. Soll mit solch einer Anordnung ein wirksamer PI Filter, das einen Kombination aus zwei Kondensatoren und einer Spule enthält, gebildet werden erhöht sich der Fertigungsaufwand zusätzlich durch das Aufbringen der einzelnen Kondensatoren, welche separat durch Schweißen, Löten, Klemmen o. ä. kontaktiert werden müssen.

Aus der EP 2 117 285 A1 ist ein Schaltungsträger zur Aufnahme eines Ferrit-Bauelements bekannt. Dabei weist das Ferrit-Bauelement eine Öffnung auf, die über eine zungenförmige Ausbildung des Schaltungsträgers schiebbar ist.

Aus der DE 10 2010 030 917 A1 ist ein elektromagnetisches Interferenzfilter für elektrische Systeme in Automobilen bekannt, welches ein Substrat mit einem Aufnahmeabschnitt aufweist, auf welchem Kondensatoren angeordnet sind. Eine Gleichtaktdrossel ist an das Substrat gekoppelt und so angeordnet, dass sie sich um den Aufnahmeabschnitt herum erstreckt. Die Gleichtaktdrossel ist dabei in einer geschlossenen, ovalen Form vorgesehen und beinhaltet einen Eisenkern.

Davon ausgehend ist es die Aufgabe der Erfindung, eine Filtereinrichtung aufzuzeigen, die mit einfachen Mitteln in elektronische Steuergeräte eingebracht werden kann und dabei die vorgenannten Nachteile vermeidet.

Die Aufgabe wird gelöst mittels einer Filtereinrichtung der eingangs genannten Art, bei der der Durchgang des Kerns derart ausgebildet ist, so dass der Aufnahmeabschnitt und die auf dem Aufnahmeabschnitt angeordneten elektronischen Komponenten durch den Durchgang durchführbar sind.

Die Erfindung beruht auf den Grundgedanken, den Kern derart auszubilden, dass es auch dann den Aufnahmeabschnitt der Leiterplatine aufgebracht bzw. aufgeschoben werden kann, auch wenn sich bereits auf dem Aufnahmeabschnitt elektronische Komponenten befinden. Auf diese Weise kann zunächst die Leiterplatine in einem ersten Schritt vollständig bestückt werden. Danach kann der Kern je nach Bedarf auf den Aufnahmeabschnitt der Leiterplatine aufgebracht werden. Mittels der erfindungsgemäßen Filtereinrichtung kann insbesondere ein Pi Filter, der notwendigerweise zwei Kondensatoren aufweisen muss, besonders einfach und flexibel zugleich realisiert werden.

Erfindungsgemäß sind der erste und zweite Kondensator derart auf der Leiterplatine angeordnet, um den Kern jeweils an seinen Stirnseiten einzuschließen.

Weiterhin ist der erste Kondensator auf dem Aufnahmeabschnitt und der zweite Kondensator benachbart zum Aufnahmeabschnitt angeordnet. Dadurch kann der Kern nur auf dem Aufnahmeabschnitt bewegt werden, so dass der zweite Kondensator vor einer Beschädigung durch verrutschen des Kerns wirksam geschützt werden kann.

Somit ist der mindestens einer der Kondensatoren im Aufnahmeabschnitt angeordnet.

Die erfindungsgemäße Filtereinrichtung wird daher vorteilhafterweise als Pi Filter ausgebildet und dadurch weitergebildet, dass die Leiterplatine einen ersten und zweiten Kondensator aufweist, die miteinander elektrisch verbunden sind und mit dem Kern zum Filtern der hochfrequenten Ströme oder elektromagnetischen Störungen zusammenwirken.

Des weiteren ist eine Ausführungsform der erfindungsgemäßen Filtereinrichtung vorteilhaft, bei der der Aufnahmeabschnitt Leiterbahnen zum Leiten eines Stroms aufweist, wobei die Leiterbahnen so angeordnet sind, um durch den Durchgang des Kerns zu verlaufen. Auf diese Weise kann der Kern durch Aufbringen auf den Aufnahmeabschnitt bzw. durch Durchführen des Aufnahmeabschnitts durch den Kern elektrisch mit der Leiterbahn gekoppelt werden. Es sind keine verdrahteten Spulen und keine zusätzlichen Verbindungsprozesse zum Fertigstellen der Filtereinrichtung mehr notwendig. Die Leiterplatine kann daher ohne Änderungen mit einem Kern bestückt werden, aber auch ohne Kern verwendet werden.

Vorteilhafterweise wird die erfindungsgemäße Filtereinrichtung dadurch weitergebildet, dass die Leiterplatine einen Hauptabschnitt aufweist, und dass der Aufnahmeabschnitt als einen vom Hauptabschnitt abstehenden Leiterplatinenteil ausgebildet ist. Die Ausführungsform ermöglicht eine besonders einfache Anpassung des Aufnahmeabschnitts an die Dimensionen des Durchgangs des Kerns, ohne dabei die Formgebung des Hauptabschnitts der Leiterplatine anpassen zu müssen. Die Filtereinrichtung kann auf diese Weise auch optional eingesetzt werden, ohne dass sich die Anordnung der elektronischen Komponenten auf dem Hauptabschnitt ändert.

Besonders bevorzugt ist dabei eine Ausführungsform der erfindungsgemäßen Filtereinrichtung, bei der ein zweiter vom Hauptabschnitt abstehender Abschnitt der Leiterplatine benachbart zum Aufnahmeabschnitt angeordnet ist. Der zweite abstehende Abschnitt kann besonders vorteilhaft zur Erhöhung der mechanischen Stabilität der Leiterplatine und des Weiteren auch zur stabileren Anbringung des Kerns auf dem Aufnahmeabschnitt genutzt werden.

Vorteilhafterweise wird die erfindungsgemäße Filtereinrichtung dadurch weitergebildet, dass die Leiterplatine eine Befestigungseinrichtung zum Befestigen des Kerns aufweist, um ein verrutschen des Kerns von der Sollposition zu verhindern.

In besonders einfacher Weise wird dies durch eine vorteilhafte Weiterbildung der erfindungsgemäßen Filtereinrichtung erreicht, bei der die Befestigungseinrichtung ein Rastelement mit einem Rastarm aufweist, der ein an seinem freien Ende angeordneten Rastvorsprung aufweist. Die Ausführungsform ermöglicht eine besonders aufwandsarme Befestigung des Kerns auf den Aufnahmeabschnitt.

Des Weiteren ist eine Ausführungsform der erfindungsgemäßen Filtereinrichtung vorteilhaft, bei der die Befestigungsvorrichtung ein auf die Leiterplatine einsteckbares Steckelement aufweist, der mit einem Abschnitt des Kerns in Eingriff bringbar ist. Das Steckelement ist vorzugsweise ohne weiteres Werkzeug auf die Leiterplatine einsteckbar. Es wird nach durchführen des Aufnahmeabschnitt durch den Durchgang des Kerns so auf die Leiterplatine eingesteckt, so dass ein herausrutschen des Kerns aus dem Aufnahmeabschnitt und vorzugsweise auch eine Beschädigung des ersten Kondensators auf dem Aufnahmeabschnitt verhindert wird. Alternativ kann der Kern auch durch den Auftrag eines Klebstoffs gegen Verrutschen gesichert werden.

Vorteilhafterweise weist die erfindungsgemäße Filtereinrichtung gemäß einer Weiterbildung ein Kern auf, bei der das Material aus Ferrit besteht. Ferrit stellt ein kostengünstiges Material dar, mit dem Kern hergestellt werden kann. Gleichzeitig können die Filterfunktionen ausreichend mit einem Kern aus Ferrit realisiert werden.

Die Aufgabe wird ferner gelöst gemäß einem zweiten Aspekt der Erfindung mittels eines Steuergeräts für eine Servolenkungsvorrichtung mit einem Gehäuse und einer Filtereinrichtung nach einem der vorstehenden Ausführungsformen.

Das erfindungsgemäße Steuergerät wird dadurch vorteilhafterweise weitergebildet, dass es eine am Gehäuse befestigbare Halteeinrichtung zum Befestigen des Kerns aufweist, um eine besonders sichere Positionierung des Kerns auf dem Aufnahmeabschnitt sicherzustellen.

Weitere bevorzugte Ausführungsformen ergeben sich aus der nachfolgenden Beschreibung eines Ausführungsbeispiels an Hand von Figuren. Es zeigen
- Fig. 1a: eine schematische Darstellung der erfindungsgemäßen Filtereinrichtung gemäß eines ersten Ausführungsbeispiels in einem ersten Verfahrenszustand,
- Fig. 1b: eine Schnittansicht des Kerns entlang der Schnittlinie A-A,
- Fig. 2: eine schematische Darstellung des ersten Ausführungsbeispiels in einem zweiten Verfahrenszustand,
- Fig. 3: eine schematische Darstellung des ersten Ausführungsbeispiels in einem dritten Verfahrenszustand, und
- Fig. 4: eine perspektivische Ansicht auf ein erfindungsgemäße Steuergerät gemäß eines ersten Ausführungsbeispiels.

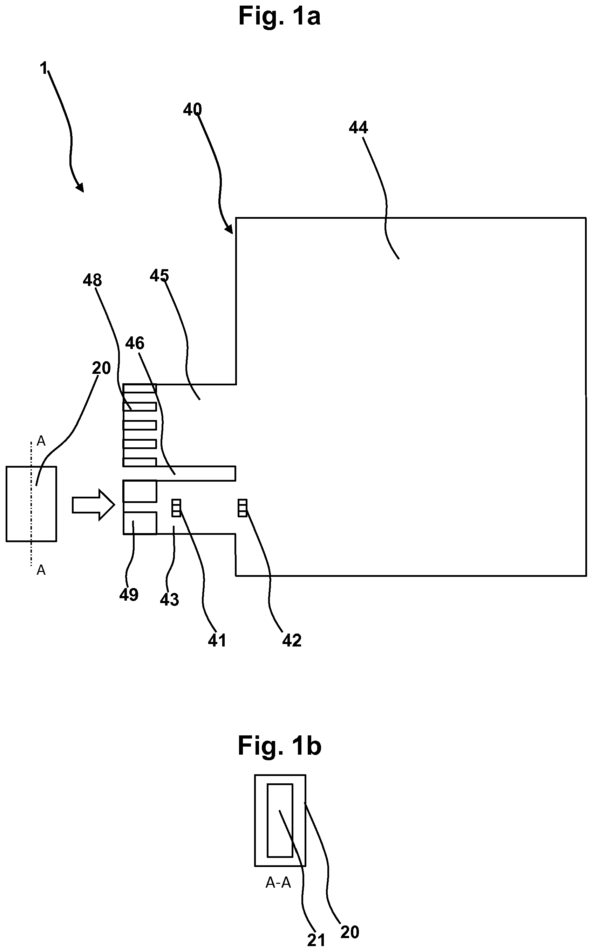

Figur 1 zeigt ein erstes Ausführungsbeispiel der erfindungsgemäßen Filtereinrichtung 1 zum Filtern von elektromagnetischen Störungen, insbesondere von Common-Mode Störungen. Die Filtereinrichtung weist einen weichmagnetischen Kern 20 mit einem Durchgang 21, eine Leiterplatine 40 mit mehreren elektronischen Komponenten 41, 42 und einem Aufnahmeabschnitt 43 auf. Der Aufnahmeabschnitt 43 der Leiterplatine 41 ist durch den Durchgang 21 durchführbar. Der Durchgang 21 ist dabei derart ausgebildet, so dass der Aufnahmeabschnitt 43 und die auf dem Aufnahmeabschnitt 43 angeordneten elektronischen Komponenten 41 durch den Durchgang 21 durchführbar sind.

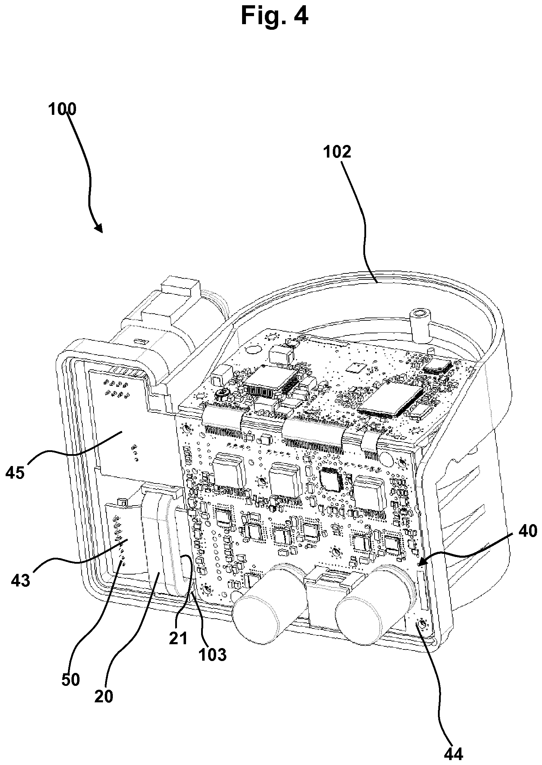

Die Leiterplatine 40 ist als Printed Circuit Board (PCB) ausgebildet und weist eine mehrere elektronischen Komponenten umfassende Schaltungsanordnung auf, wie in Figur 4 dargestellt. In den Figuren 1-3 sind jeweils nur ein erster und zweiter Kondensator 41, 42 exemplarisch dargestellt.

Die Leiterplatine 40 weist einen Hauptabschnitt 44 auf, auf der die elektronischen Komponenten zum Ausführen der Hauptfunktion der Leiterplatine 40 angeordnet sind. Ferner weist die Leiterplatine 40 den Aufnahmeabschnitt 43 auf, der als ein vom Hauptabschnitt 44 abstehendes Leiterplatinenteil ausgebildet ist. Ein zweiter vom Hauptabschnitt 44 abstehender Abschnitt 45 der Leiterplatine 40 ist benachbart zum Aufnahmeabschnitt 43 angeordnet. Die einzelnen Abschnitte 43, 44, 45 sind einstückig als eine Leiterplatine 40 ausgebildet.

Der Aufnahmeabschnitt 43 weist eine im Wesentlichen rechteckige Grundform auf, dessen Breite in etwa der Breite des Durchgangs 21 des Kerns 20 entspricht. Benachbart dazu ist der zweite Abschnitt 45 auch mit einer rechteckigen Grundform angeordnet, so dass die zwei Abschnitte einen Schlitz 46 bilden, in der beispielsweise eine Befestigungseinrichtung 50 angeordnet sein kann. Wie in Figur 4 gezeigt, kann die Form der jeweiligen Abschnitte 43, 45 je nach Bedarf variieren.

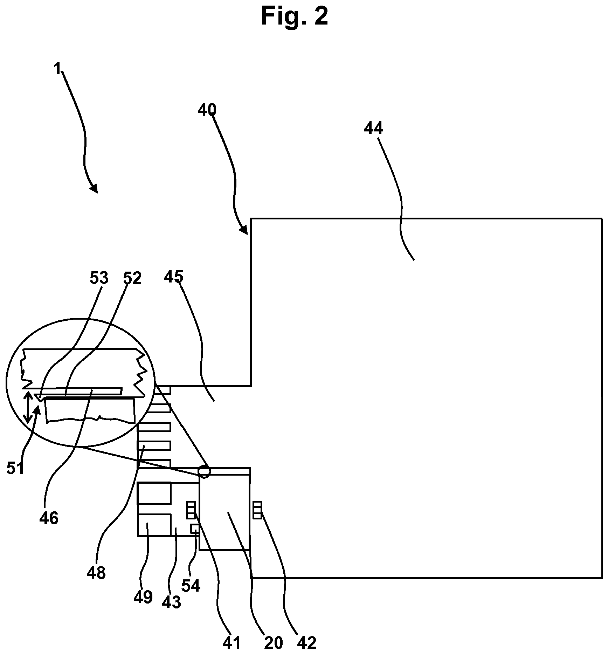

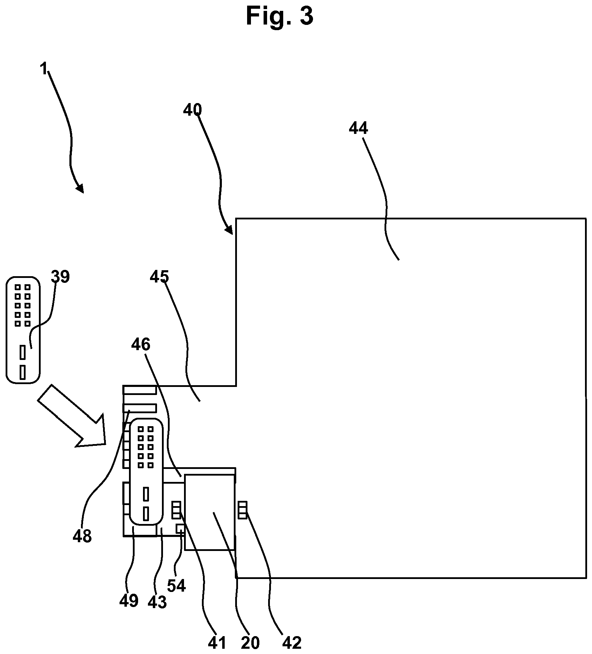

Auf dem Aufnahmeabschnitt 43 sind ferner Leiterbahnen (nicht in den Figuren gezeigt) zum Leiten eines Stroms aufgebracht, wobei die Leiterbahnen so angeordnet sind, um durch den Durchgang 21 des Kerns 20 zu verlaufen, wenn der Kern 20 auf den Aufnahmeabschnitt 43 aufgebracht bzw. -schoben wurde, wie in Figur 2 gezeigt. Am freien Ende des Aufnahmeabschnitts 43 befinden sich Anschlussplatinen 49, über die die Leiterplatine 40 bspw. mit einer Stromquelle verbindbar ist. Der Aufnahmeabschnitt 43 kann auch als Stecker verwendet werden, um eine elektrische Verbindung zu einer Stromquelle oder anderen Geräten herzustellen. Denkbar ist es auch das freie Ende des Aufnahmeabschnitts 43 mit für Pressfit Verbindungen geeigneten Durchkontaktierungen zu versehen, um eine besonders einfache und kostengünstige elektrische Verbindung z.B. zu einem Gerätestecker zu realisieren, siehe Figur 3. Parallel dazu kann der zweite Abschnitt 45 mit weiteren Kontakten 48 zur Übertragung von Signalen versehen werden.

Der Kern 20 ist aus einem weichmagnetischen Material, beispielsweise Ferrit, hergestellt und ist ringförmig ausgebildet. Die Grundform des Kerns kann dabei variieren. In diesem Ausführungsbeispiel ist sie exemplarisch rechteckig mit einer rechteckigen Ausnehmung dargestellt, wie in der Schnittansicht aus Figur 1b zu sehen. Sie kann auch mit abgerundeten Ecken oder oval förmig ausgebildet sein. Der Durchgang 21 des Kerns 20 ist dabei so dimensioniert, dass der Kern auf den Aufnahmeabschnitt 43 aufgeschoben werden kann, auch wenn sich elektronische Komponenten, insbesondere ein Kondensator 41, auf dem Aufnahmeabschnitt 43 bereits befinden.

Die elektronischen Komponenten 41, 42 umfassen unter anderem einen ersten und zweiten Kondensator 41, 42, die auf der Leiterplatine 40 angeordnet sind, und die miteinander elektrisch verbunden sind und mit dem Kern 20 zum Filtern der Störungen zusammenwirken. Der erste Kondensator ist als Eingangs- und der zweite Kondensator 42 ist als ausgangsseitiger Filterkondensator ausgebildet und sind bereits vor aufbringen des Kerns 20 auf den Aufnahmeabschnitt 43 auf der Leiterplatine 40 angeordnet. Durch einfaches aufbringen bzw. aufschieben des Kerns 20 entsteht ein vollwertiger PI Filter.

Vorteilhafterweise ist der erste Kondensator 41 auf dem Aufnahmeabschnitt 43 und der zweite Kondensator 42 benachbart zum Aufnahmeabschnitt 43 angeordnet ist. Wie in Figur 2 dargestellt, liegt der Kern 20 an einer Kante der Leiterplatine 40 an und kommt daher nicht in Kontakt mit dem zweiten Kondensator 42. Diese ist daher wirksam vor einer Beschädigung durch einen verrutschenden Kern 20 geschützt. Ferner sind der erste und zweite Kondensator 41, 42 derart auf der Leiterplatine 40 angeordnet, um den Kern 20 jeweils an seinen Stirnseiten einzuschließen.

Die erfindungsgemäße Filtereinrichtung 1 hat den Vorteil, dass eine elektrische Funktion eines PI Filters ohne die dafür normalerweise notwendige Kontaktierung herstellen zu müssen, eingebracht werden kann. Damit kann die Leiterplatine 40 wahlfrei mit unterschiedlichen Arten von Kernen, unterschiedlicher Materialien und Geometrie, aber auch ohne Kern verwendet werden, ohne die Schaltungsanordnung der auf der Leiterplatinen sich befindenden elektronischen Komponenten oder gar der Leiterplatine selbst ändern zu müssen.

Um ein verrutschen des Kerns 20 auf dem Aufnahmeabschnitt 43 zu verhindern, weist die Leiterplatine 20 eine Befestigungseinrichtung zum Befestigen des Kerns 20 auf.

Zum einen umfasst die Befestigungseinrichtung eine Rastelement 51. Das Rastelement 51 weist einen Rastarm 52 auf, an dessen freien Ende ein Rastvorsprung 53 ausgebildet ist. Die Länge des Rastarms 52 sowie die Position des Rastvorsprungs 43 ist derart ausgebildet, dass es mit der Außenkante des Kerns 20 in Eingriff kommt, sobald der Kern 20 auf dem Aufnahmeabschnitt 43 vollständig aufgeschoben wurde, wie in Figur 2 dargestellt. Der Rastvorsprung 53 hat eine im wesentlichen dreieckörmige Form, wobei die zur Bewegungsrichtung des Kerns 20 geneigten Kontaktflächen des Vorsprung 53 dafür sorgen, dass der Rastarm 52 bei einem Kontakt mit dem Kern 20 nach oben gebogen wird, und der Kern unter den Rastarm 52 geschoben bzw. aus dem Rastarm 52 rausgeschoben werden kann. Das Rastelement 41 kann dazu verwendet werden, dass es den Kern 50 für den Montageprozess nur vorübergehend in einer Position befestigt.

Für eine endgültige Arretierung bzw. Befestigung des Kerns 20 kann ein auf die Leiterplatine 40 einsteckbares Steckelement 54 verwendet werden, der mit einem Abschnitt des Kerns 20 in Eingriff bringbar ist. Das Steckelement 54 wird auf die Leiterplatine 40 eingesteckt, sobald der Kern 20 in der auf den Aufnahmeabschnitt 43 aufgeschobene Position, wie in Figur 2 gezeigt, sich befindet. Das Steckelement 54 ragt im eingesteckten Zustand aus der Leiterplatine 40 so weit heraus, dass es die Bewegung des Kerns 20 aus dem Aufnahmeabschnitt 43 heraus blockiert.

Die Figuren 1-3 zeigen des Weiteren auch einzelne Verfahrensschritte zum herstellen der erfindungsgemäßen Filtereinrichtung, die folgende Schritte aufweist:
a) Anbringen des ersten und zweiten Kondensator 41, 42 auf die Leiterplatine 40,
b) Aufschieben des Kerns 20 auf den Aufnahmeabschnitt 43,
c) Anbringen des Einpreßkontaktes 39 auf die Leiterplatine 40.
Optional kann der Verfahrensschritte B) dadurch ergänzt werden, dass ein Steckelement 54 auf die Leiterplatine angebracht wird.

Figur 4 zeigt die Anwendung der erfindungsgemäßen Filtereinrichtung 1 in einem Steuergerät 100 für eine Servolenkungsvorrichtung mit einem Gehäuse 102, wobei die Filtereinrichtung 1 innerhalb des Gehäuses 102 angeordnet ist. Der Kern 20 ist in diesem Ausführungsbeispiels mittels eines am Gehäuse 102 befestigbare Halteeinrichtung 103. die Halteeinrichtung 103 umfasst zwei Haltekissen mit zwei überstehenden Lippen, zwischen denen der Kern 20 eingefasst ist. Die Haltekissen sind vorzugsweise aus einem elastischen Material ausgebildet und können zwischen dem Kern 20 und dem Gehäuse 102 bzw. dem zweiten Abschnitt 45 eingedrückt werden.

## Patentansprüche

1. Filtereinrichtung (1) zum Filtern von elektrischen Strömen oder elektromagnetischen Störungen, insbesondere von Common-Mode Störungen, aufweisend
einen weichmagnetischen Kern (20) mit einem Durchgang (21),
eine Leiterplatine (40) mit mehreren elektronischen Komponenten (41, 42) und einem Aufnahmeabschnitt (43), wobei der Aufnahmeabschnitt (43) der Leiterplatine (40) durch den Durchgang (21)durchführbar ist, wobei der Durchgang (21) derart ausgebildet ist, so dass der Aufnahmeabschnitt (43) und die auf dem Aufnahmeabschnitt (43) angeordneten elektronischen Komponenten (41, 42) durch den Durchgang (21) durchführbar sind,
**dadurch gekennzeichnet, dass**
- die Leiterplatine (40) einen ersten und zweiten Kondensator (41, 42) aufweist, die miteinander elektrisch verbunden sind und mit dem Kern (20) zum Filtern zusammenwirken,
- der erste und zweite Kondensator (41, 42) derart auf der Leiterplatine (40) angeordnet sind, um den Kern (20) jeweils an seinen Stirnseiten einzuschließen und
- der erste Kondensator (41) auf dem Aufnahmeabschnitt (43) und der zweite Kondensator (42) benachbart zum Aufnahmeabschnitt (43) angeordnet ist.

2. Filtereinrichtung (1) nach einem der vorstehenden Ansprüche, **dadurch gekennzeichnet, dass** mindestens eines der mehreren elektronischen Komponenten (41, 42), im Aufnahmeabschnitt (43) angeordnet ist.

3. Filtereinrichtung (1) nach einem der vorstehenden Ansprüche, **dadurch gekennzeichnet, dass** der Aufnahmeabschnitt (43) Leiterbahnen zum Leiten eines Stroms aufweist, wobei die Leiterbahnen so angeordnet sind, um durch den Durchgang (21) des Kerns (21) zu verlaufen.

4. Filtereinrichtung (1) nach einem der vorstehenden Ansprüche, **dadurch gekennzeichnet, dass** die Leiterplatine (40) einen Hauptabschnitt (44) aufweist, und dass der Aufnahmeabschnitt (43) als einen vom Hauptabschnitt (44) abstehenden Leiterplatinenteil ausgebildet ist.

5. Filtereinrichtung (1) nach Anspruch 7, **dadurch gekennzeichnet, dass** ein zweiter vom Hauptabschnitt abstehender Abschnitt (45) der Leiterplatine (40) benachbart zum Aufnahmeabschnitt (43) angeordnet ist.

6. Filtereinrichtung (1) nach einem der vorstehenden Ansprüche, **dadurch gekennzeichnet, dass** die Leiterplatine (40) eine Befestigungseinrichtung (51, 54) zum Befestigen des Kerns (20) aufweist.

7. Filtereinrichtung (1) nach Anspruch 9, **dadurch gekennzeichnet, dass** die Befestigungseinrichtung (42) ein Rastelement (51) mit einem Rastarm (52) aufweist, der ein an seinem freien Ende angeordneten Rastvorsprung (53) aufweist.

8. Filtereinrichtung (1) nach einem der Ansprüche 9 und 10, **dadurch gekennzeichnet, dass** die Befestigungsvorrichtung ein auf die Leiterplatine einsteckbares Steckelement (54) aufweist, der mit einem Abschnitt des Kerns (20) in Eingriff bringbar ist.

9. Filtereinrichtung (1) nach einem der vorstehenden Ansprüche, **dadurch gekennzeichnet, dass** das Material des Kerns (20) Ferrit ist.

10. Steuergerät (100) für eine Servolenkungsvorrichtung mit einem Gehäuse (102) und einer Filtereinrichtung (1) nach einem der vorstehenden Ansprüche.

11. Steuergerät (100) nach Anspruch 10, **gekennzeichnet durch** eine am Gehäuse (102) befestigbare Halteeinrichtung (103) zum Befestigen des Kerns (20).

## Claims

1. Filter device (1) for filtering electric currents or electromagnetic interference, in particular common-mode interference, having
a soft-magnetic core (20) with a passage (21),
a circuit board (40) with a plurality of electronic components (41, 42) and a reception section (43), wherein the reception section (43) of the circuit board (40) is able to be passed through by the passage (21), wherein the passage (21) is designed such that the reception section (43) and the electronic components (41, 42) arranged on the reception section (43) are able to be passed through the passage (21),
**characterized in that**
- the circuit board (40) has a first and a second capacitor (41, 42) that are electrically connected to one another and interact with the core (20) for filtering purposes,
- the first and the second capacitor (41, 42) are arranged on the circuit board (40) so as each to enclose the core (20) on its end sides and
- the first capacitor (41) is arranged on the reception section (43) and the second capacitor (42) is arranged next to the reception section (43).

2. Filter device (1) according to one of the preceding claims, **characterized in that** at least one of the plurality of electronic components (41, 42) is arranged in the reception section (43).

3. Filter device (1) according to either of the preceding claims, **characterized in that** the reception section (43) has conductor tracks for conducting a current, wherein the conductor tracks are arranged so as to run around the passage (21) in the core (21).

4. Filter device (1) according to one of the preceding claims, **characterized in that** the circuit board (40) has a main section (44) and **in that** the reception section (43) is designed as a circuit board part protruding from the main section (44).

5. Filter device (1) according to Claim 7, **characterized in that** a second section (45), protruding from the main section, of the circuit board (40) is arranged next to the reception section (43).

6. Filter device (1) according to one of the preceding claims, **characterized in that** the circuit board (40) has an attachment device (51, 54) for the attachment of the core (20).

7. Filter device (1) according to Claim 9, **characterized in that** the attachment device (42) has a latching element (51) with a latching arm (52) that has a latching projection (53) arranged on its free end.

8. Filter device (1) according to either of Claims 9 and 10, **characterized in that** the attachment device has a plug element (54) able to be plugged onto the circuit board and that is able to be brought into engagement with a section of the core (20).

9. Filter device (1) according to one of the preceding claims, **characterized in that** the material of the core (20) is ferrite.

10. Controller (100) for a power steering apparatus with a housing (102) and a filter device (1) according to one of the preceding claims.

11. Controller (100) according to Claim 10, **characterized by** a holding device (103), able to be attached to the housing (102), for the attachment of the core (20).

## Revendications

1. Dispositif de filtrage (1) permettant de filtrer des courants électriques ou des interférences électromagnétiques, en particulier des interférences de mode commun, comprenant
un noyau magnétique doux (20) pourvu d'un passage (21),
une carte de circuits imprimés (40) pourvue de plusieurs composants électroniques (41, 42) et d'une partie de réception (43), la partie de réception (43) de la carte de circuits imprimés (40) pouvant être guidée à travers le passage (21), le passage (21) étant réalisé de telle sorte que la partie de réception (43) et les composants électroniques (41, 42) disposés sur la partie de réception peuvent être guidés à travers le passage (21),
**caractérisé en ce que**
- la carte de circuits imprimés (40) comprend un premier et un deuxième condensateur (41, 42) qui sont reliés électriquement l'un à l'autre et coopèrent avec le noyau (20) en vue du filtrage,
- le premier et le deuxième condensateur (41, 42) sont disposés sur la carte de circuits imprimés (40) de telle sorte qu'ils entourent le noyau (20) respectivement sur ses faces frontales, et
- le premier condensateur (41) est disposé sur la partie de réception (43) et le deuxième condensateur (42) est disposé à côté de la partie de réception (43).

2. Dispositif de filtrage (1) selon l'une quelconque des revendications précédentes, **caractérisé en ce qu'**au moins l'un des plusieurs composants électroniques (41, 42) est disposé dans la partie de réception (43).

3. Dispositif de filtrage (1) selon l'une quelconque des revendications précédentes, **caractérisé en ce que** la partie de réception (43) comprend des pistes conductives pour conduire un courant, les pistes conductives étant disposées de telle sorte qu'elles passent à travers le passage (21) du noyau (21).

4. Dispositif de filtrage (1) selon l'une quelconque des revendications précédentes, **caractérisé en ce que** la carte de circuits imprimés (40) comprend une partie principale (44), et **en ce que** la partie de réception (43) est réalisée sous la forme d'une partie de carte de circuits faisant saillie depuis la partie principale (44) .

5. Dispositif de filtrage (1) selon la revendication 7, **caractérisé en ce qu'**une deuxième partie (45), faisant saillie depuis la partie principale, de la carte de circuits imprimés (40) est disposée à côté de la partie de réception.

6. Dispositif de filtrage (1) selon l'une quelconque des revendications précédentes, **caractérisé en ce que** la carte de circuits imprimés (40) comprend un dispositif de fixation (51, 54) pour fixer le noyau (20) .

7. Dispositif de filtrage (1) selon la revendication 9, **caractérisé en ce que** le dispositif de fixation (42) comprend un élément d'arrêt (51) pourvu d'un bras d'arrêt (52) qui comprend une saillie d'arrêt (53) disposée à son extrémité libre.

8. Dispositif de filtrage (1) selon l'une quelconque des revendications 9 et 10, **caractérisé en ce que** le dispositif de fixation comprend un élément enfichable (54) pouvant être enfiché sur la carte de circuits imprimés et pouvant être mis en prise avec une partie du noyau (20).

9. Dispositif de filtrage (1) selon l'une quelconque des revendications précédentes, **caractérisé en ce que** le matériau du noyau (20) est du ferrite.

10. Contrôleur (100) pour un dispositif de direction assistée, comprenant un boîtier (102) et un dispositif de filtrage (1) selon l'une quelconque des revendications précédentes.

11. Contrôleur (100) selon la revendication 10, **caractérisé par** un dispositif de maintien (103) pour fixer le noyau (20) et pouvant être fixé au boîtier (102) .
